# EUROPEAN PATENT APPLICATION

(11) **EP 4 383 430 A1**
(43) Date of publication of application: **12.06.2024**
(21) Application number: 21969371.0
(22) Date of filing: 28.12.2021
(51) Int. Cl.: H01M 50/289, G01R 31/36

(54) **BATTERY SAMPLING ASSEMBLY, BATTERY AND MANUFACTURING METHOD THEREFOR, AND ELECTRIC DEVICE**

(71) Applicant: Contemporary Amperex Technology Co., Limited, Ningde, Fujian 352100 (CN)
(72) Inventor: WANG, Lili, Ningde, Fujian 352100 (CN); LI, Pengfei, Ningde, Fujian 352100 (CN); HU, Yaowen, Ningde, Fujian 352100 (CN); QI, Congcheng, Ningde, Fujian 352100 (CN); ZHANG, Zhihong, Ningde, Fujian 352100 (CN); ZHENG, Shixiong, Ningde, Fujian 352100 (CN)
(74) Representative: Rowlands, Stuart Michael
(86) International application number: PCT/CN2021/142209
(87) International publication number: WO 2023/122993

(57) **Abstract**

Disclosed in the present disclosure are a battery sampling assembly, a battery and a manufacturing method therefor, and an electric device. Provided in the embodiments of the present invention is a battery sampling assembly. The battery sampling assembly comprises a bearing member, a first sampling member and a second sampling member. The first sampling member and the second sampling member are fixed on the bearing member. The first sampling member is used for sampling a first structure of the battery, and the second sampling member is used for sampling a second structure of the battery.

## Description

### TECHNICAL FIELD

This disclosure relates to the field of batteries, and in particular, to a battery sampling assembly, a battery and a manufacturing method thereof, and an electric device.

### BACKGROUND

To realize proper operation of a battery, various status signals of the battery are sampled when in states such as charging and discharging. In this way, whether the battery is operating properly can be determined based on the sampled status signals. For example, if a battery fails to charge or discharge properly, charging and/or discharging of the battery can be stopped in a timely manner to ensure safe use of electricity.

A sampling assembly is required to sample the status signals of a battery. However, for a sampling assembly in the related art, problems such as difficulty in assembling and low assembling efficiency often occur when the sampling assembly is being mounted in a battery.

### SUMMARY

In view of the foregoing problems, this disclosure provides a battery sampling assembly, a battery and a manufacturing method thereof, and an electric device, which can partly solve the problems of difficulty in assembly and low assembly efficiency encountered when the sampling assembly is being mounted in the battery.

According to a first aspect, an embodiment of this disclosure provides a battery sampling assembly, including a carrier part, a first sampling part, and a second sampling part; where
the first sampling part and the second sampling part are fixed to the carrier part;
the first sampling part is configured to sample a first structure of a battery; and
the second sampling part is configured to sample a second structure of the battery.

In the embodiments of this disclosure, the first sampling part and the second sampling part are fixed relative to each other by using the carrier part. In this way, problems, caused by scattering of the first sampling part and the second sampling part, of a lengthy time to connect a battery sampling assembly to the battery and low assembly efficiency are alleviated. This improves the efficiency of mounting the battery sampling assembly in the battery.

In an embodiment, the battery includes a plurality of battery packs, and the first structure includes two poles of opposite polarity of adjacent battery packs.

In this way, the first structure connected to the first sampling part is an electrical connection between the two poles of opposite polarity of adjacent battery packs, such electrical connection enables the two adjacent battery packs to be connected in series, and the first sampling assembly can be used to sample the two adjacent battery packs.

Based on the foregoing solution, the battery includes a plurality of battery packs, and the second structure includes a housing of a battery cell in a battery pack.

In the embodiments of this disclosure, the second sampling part is connected to the second structure, and the second structure is a housing of a battery pack. In other words, the second sampling part samples electrical signals of the housing.

Based on the foregoing solution, the first sampling part is provided in a quantity of N and the second sampling part is provided in a quantity of N, where N is a positive integer equal to or greater than 2.

In the embodiments of this disclosure, N first sampling parts and N second sampling parts are provided in a battery sampling assembly. In other words, the battery sampling assembly is a structure that can sample a plurality of battery packs. If the first sampling part and the second sampling part are both provided in plurality, it is more necessary that the first sampling parts and the second sampling parts use the same carrier part to be held fixed relative to each other, which improves the integrity of the battery sampling assembly.

Based on the foregoing solution, the n-th first sampling part is configured to sample a first pole of the 2n-th battery pack and a second pole of the (2n-1)-th battery pack; and
the n-th second sampling part is configured to sample a housing of the (2n-1)-th battery pack;
where n is a positive integer less than or equal to N.

This embodiment of this disclosure specifically defines a specific electrical connection between the first sampling part and the poles of the battery packs, and further defines a specific electrical connection between the second sampling part and the housing of the battery packs.

Based on the foregoing solution, the n-th first sampling part is configured to sample a first pole of the 2n-th battery pack and a second pole of the (2n+1)-th battery pack; where the second pole and the first pole are opposite in polarity; and
the n-th second sampling part is configured to sample a housing of a battery cell in the 2n-th battery pack.

This embodiment of this disclosure specifically defines an electrical connection between the first sampling part and the poles of the battery packs and a specific electrical connection between the second sampling part and the housing of the battery packs.

The battery sampling assembly further includes a circuit board.

The circuit board is electrically connected to the first sampling part through a first line and electrically connected to the second sampling part through a second line.

The circuit board herein is connected to the first sampling part and the second sampling part through the first line and the second line respectively, and the circuit board can conduct signals sampled by the first sampling part and the second sampling part to a battery management system (BMS) or the like.

Based on the foregoing solution, the battery sampling assembly further includes a connector.

The connector connects the circuit board and the carrier part.

The battery sampling assembly herein further introduces the connector, and the connector can at least be used to reinforce the relative position between the circuit board and the carrier part.

Based on the foregoing solution, the circuit board is a flexible printed circuit board, and the flexible printed circuit board and the carrier part are integrally formed into an integrated structure.

If the circuit board is a flexible printed circuit board, the first sampling part, the second sampling part, and various lines can be integrated on the flexible printed circuit board. In this case, a substrate of the flexible printed circuit board is directly used as a carrier part, so that the first sampling part and the second sampling part are fixed relative to each other.

Based on the foregoing solution, the first sampling part includes:
a first metal sheet, electrically connected to the first line; and
a second metal sheet, laser welded to the first metal sheet and used for electrical connection with two poles of opposite polarity of adjacent battery packs.

The first metal sheet may be of a structure facilitating electrical connection with the first line, and the second metal sheet may be connected to two poles for a better electrical connection.

In an embodiment, the carrier part includes:
a first opening, aligned with a connection region of the first sampling part; and
a second opening, aligned with a connection region of the second sampling part.

The connection regions of the first opening and the second opening on the carrier part are aligned, so that the connection region of the first sampling part is exposed at the first opening and the connection region of the second sampling part is exposed at the second opening. This facilitates electrically connecting the first sampling part and the second sampling part to the battery packs.

In an embodiment, the carrier part includes a hot-pressing film, and the hot-pressing film is used to fix, by hot pressing, the first sampling part and the second sampling part.

In the embodiments of this disclosure, the carrier part is a hot-pressing film, and the manufacturing cost of the hot-pressing film is low.

In an embodiment, the hot-pressing film includes:
a first film layer and a second film layer; where the first sampling part and the second sampling part are hot pressed between the first film layer and the second film layer.

A two-layer hot-pressing film is used to hot press the first sampling part and the second sampling part. In addition to low cost, this ensures the stability of the first sampling part and the second sampling part fixed by the hot-pressing film.

In an embodiment, one surface of the carrier part is provided with an adhesive layer and a protective layer covering a surface of the adhesive layer. The adhesive layer is used to fix the battery sampling assembly.

In a process of connecting the battery sampling assembly to the battery, the adhesive layer can be used to temporarily fix battery packs relative to the battery sampling assembly. This facilitates battery assembling and further improves battery assembling efficiency.

According to a second aspect, an embodiment of this disclosure provides a battery, including:
the battery sampling assembly according to any one of the foregoing embodiments of the first aspect.

If the battery includes the battery sampling assembly provided in any one of the foregoing embodiments, the first sampling part and the second sampling part are fixed relative to each other in a battery assembling process. In this way, the battery sampling assembly can be fixed on a battery pack more easily, and the battery assembling efficiency is improved.

Based on the foregoing solution, the battery includes:
a battery pack, with one battery pack including two battery cells connected in series;
where the battery pack is electrically connected to the battery sampling assembly.

The battery pack included in the battery provided in the embodiments of this disclosure includes two battery cells connected in series. Two battery cells are connected in series to form a battery pack. This can increase the battery capacity of a battery pack more conveniently and easily.

Based on the foregoing solution, 2S battery packs are provided.

The battery sampling assembly includes a first battery sampling assembly and a second battery sampling assembly.

The first battery sampling assembly includes S first sampling parts and S second sampling parts.

The second battery sampling assembly includes S-1 first sampling parts and S-1 second sampling parts.

The second sampling parts of the first battery sampling assembly each are electrically connected to a housing of an odd-numbered battery pack; and the second sampling parts of the second battery sampling assembly each are electrically connected to a housing of an even-numbered battery pack.

In the embodiments of this disclosure, the battery includes two battery sampling assemblies, and the electrical connection between the battery pack and the battery sampling assemblies is specifically defined.

According to a third aspect, an embodiment of this disclosure provides an electric device. The electric device includes:
any one of the foregoing batteries.

The electric device in the embodiments of this disclosure uses the battery according to any one of the foregoing embodiments, and therefore features high manufacturing efficiency.

According to a fourth aspect, an embodiment of this disclosure provides a method for manufacturing a battery sampling assembly, including:
arranging a first sampling part and a second sampling part; and
fixing, by hot pressing, the first sampling part and the second sampling part to a carrier part.

The first sampling part and the second sampling part are arranged and then fixed to the carrier part, so that the battery sampling assembly allows the first sampling part and the second sampling part to be fixed relative to each other due to introduction of the carrier part.

Based on the foregoing solution, before fixing the first sampling part and the second sampling part to a carrier part, the method further includes:
electrically connecting a first line of a circuit board and the first sampling part; and
electrically connecting a second line of the circuit board and the second sampling part.

The first sampling part and the second sampling part are electrically connected to the circuit board before being fixed to the carrier part. In this way, more operation space can be provided for connecting the circuit board to the first sampling part and the second sampling part.

Based on the foregoing solution, the method further includes:
fixing the carrier part and the circuit board by using a connector.

After the first sampling part and the second sampling part are fixed to the carrier part, the carrier part and the circuit board can be fixed to each other by using the connector. In this way, integrity of the entire battery sampling assembly is improved.

According to a fifth aspect, an embodiment of this disclosure provides a battery manufacturing method, including:
arranging S battery packs to form a battery pack array;
fixing a battery sampling assembly to the battery pack array; and
connecting a first sampling part of the battery sampling assembly to a first structure of a battery, and electrically connecting a second sampling part of the battery sampling assembly to a second structure of the battery.

An incoming material used in the battery in the embodiments of this disclosure is the battery sampling assembly provided in any one of the foregoing technical solutions. This simplifies battery manufacturing and improves battery manufacturing efficiency.

Based on the foregoing solution, the first structure includes two poles of opposite polarity of adjacent battery packs.

Based on the foregoing solution, the second structure includes a housing of a battery cells in a battery pack.

Based on the foregoing solution, connecting a first sampling part of the battery sampling assembly to a first structure of a battery, and electrically connecting a second sampling part of the battery sampling assembly to a second structure of the battery includes:
electrically connecting the n-th first sampling part of the first battery sampling assembly to a first pole of the 2n-th battery pack and a second pole of the (2n-1)-th battery pack; and
electrically connecting the n-th first sampling part of the second battery sampling assembly to the first pole of the 2n-th battery pack and a second pole of the (2n+1)-th battery pack;
   or,
electrically connecting the n-th second sampling part of the first battery sampling assembly to a housing of the (2n-1)-th battery pack; and
electrically connecting the n-th second sampling part of the second battery sampling assembly to a housing of a battery cell in the 2n-th battery pack.

Based on the foregoing solution, fixing a battery sampling assembly to the battery pack array includes:
removing a protective layer on the back of a carrier part of the battery sampling assembly to expose an adhesive layer covered by the protective layer; and
bonding the battery sampling assembly to the battery pack array by using the adhesive layer.

The adhesive layer is used to fix the battery sampling assembly to the battery pack. After fixing, the first sampling parts and the second sampling parts in the battery sampling assembly are primarily aligned with the first structures and the second structures of the battery pack. In this case, positions for alignment do not need to be adjusted or only need to be adjusted slightly for specific electrical connection between the first sampling parts and the first structures and between the second sampling parts and the second structures. Therefore, the overall battery manufacturing efficiency is improved.

The foregoing description is merely an overview of the technical solution of this disclosure. For a better understanding of the technical means in this disclosure such that they can be implemented according to the content of the specification, and to make the above and other objectives, features and advantages of this disclosure more obvious and easier to understand, the following describes specific embodiments of this disclosure.

### BRIEF DESCRIPTION OF DRAWINGS

Persons of ordinary skill in the art can clearly understand various other advantages and benefits by reading the detailed description of the preferred embodiments below. The accompanying drawings are merely intended to illustrate the purposes of the preferred implementations and should not be construed as a limitation on this disclosure. Moreover, throughout the accompanying drawings, the same reference signs represent the same parts. In the accompanying drawings:
FIG. 1 is a schematic diagram of a structure of a battery sampling assembly according to some embodiments of this disclosure;
FIG. 2 is a schematic diagram of a structure of a battery sampling assembly according to some embodiments of this disclosure;
FIG. 3 is a schematic diagram of a structure of a battery sampling assembly according to some embodiments of this disclosure;
FIG. 4 is a schematic diagram of a structure of a battery sampling assembly according to some embodiments of this disclosure;
FIG. 5 is a schematic diagram of a structure of a battery according to some embodiments of this disclosure;
FIG. 6 is a schematic diagram of a structure of a battery according to some embodiments of this disclosure;
FIG. 7 is a schematic diagram of a structure of an electric device according to some embodiments of this disclosure;
FIG. 8 is a schematic flowchart of a method for manufacturing a battery sampling assembly according to some embodiments of this disclosure; and
FIG. 9 is a schematic flowchart of a battery manufacturing method according to some embodiments of this disclosure.

Reference signs in the description of embodiments are as follows:
carrier part 11;
first sampling assembly 12, first metal sheet 121, second metal sheet 122;
second sampling assembly 13;
connector 14;
circuit board 15;
first line 16;
second line 17;
battery pack 20, battery cell 221, pole 222, and top cover 223.

### DESCRIPTION OF EMBODIMENTS

The following describes in detail the embodiments of technical solutions of this disclosure with reference to the accompanying drawings. The following embodiments are merely intended for a clearer description of the technical solutions of this disclosure and therefore are used as just examples which do not constitute any limitations on the protection scope of this disclosure.

Unless otherwise defined, all technical and scientific terms used herein shall have the same meaning as commonly understood by those skilled in the art to which this disclosure belongs. The terms used herein are intended to merely describe the specific embodiments rather than to limit this disclosure. The terms "include", "comprise", and "have" and any other variations thereof in the specification, claims and brief description of drawings of this disclosure are intended to cover non-exclusive inclusions.

In the description of the embodiments of this disclosure, the terms "first", "second", and the like are merely intended to distinguish between different objects, and shall not be understood as any indication or implication of relative importance or any implicit indication of the number, sequence or primary-secondary relationship of the technical features indicated. In the description of this disclosure, "a plurality of" means at least two unless otherwise specifically stated.

In this specification, reference to an "embodiment" means that specific features, structures or characteristics described with reference to the embodiment may be incorporated in at least one embodiment of this disclosure. The word "embodiment" appearing in various places in the specification does not necessarily refer to the same embodiment or an independent or alternative embodiment that is exclusive of other embodiments. It is explicitly or implicitly understood by persons skilled in the art that the embodiments described herein may be combined with other embodiments.

In the description of the embodiments of this disclosure, the term "and/or" is only an associative relationship for describing associated objects, indicating that three relationships may be present. For example, A and/or B may indicate the following three cases: presence of only A, presence of both A and B, and presence of only B. In addition, the character "/" in this specification generally indicates an "or" relationship between contextually associated objects.

In the description of the embodiments of this disclosure, the term "a plurality of" means more than two (inclusive). Similarly, "a plurality of groups" means more than two (inclusive) groups, and "a plurality of pieces" means more than two (inclusive) pieces.

In the description of the embodiments of this disclosure, the orientations or positional relationships indicated by the technical terms "center", "longitudinal", "transverse", "length", "width", "thickness", "upper", "lower", "front", "rear", "left", "right", "vertical", "horizontal", "top", "bottom", "inside", "outside", "clockwise", "counterclockwise", "axial", "radial", "circumferential", and the like are based on the orientations or positional relationships as shown in the accompanying drawings. These terms are used merely for ease and brevity of the description of the embodiments of this disclosure rather than indicating or implying that the means or components mentioned must have specific orientations or must be constructed or manipulated according to specific orientations, and therefore shall not be construed as any limitations on the embodiments of this disclosure.

In the description of the embodiments of this disclosure, unless otherwise specified and defined explicitly, the terms "mount", "connect", "join", and "fasten" should be understood in their general senses. For example, they may refer to a fixed connection, a detachable connection, or an integral connection, may refer to a mechanical connection or an electrical connection, and may refer to a direct connection, an indirect connection via an intermediate medium, an internal communication between two elements, or an interaction between two elements. Persons of ordinary skill in the art can understand specific meanings of these terms in this disclosure as appropriate to specific situations.

Currently, from a perspective of the market development, application of traction batteries is being more extensive. Traction batteries have not only been used in energy storage power supply systems such as hydroelectric power plants, thermal power plants, wind power plants, and solar power plants, but have also been widely used in many other fields including electric transportation tools such as electric bicycles, electric motorcycles, and electric vehicles, military equipment, and aerospace. With continuous expansion of application fields of traction batteries, market demands for the traction batteries are also expanding.

To ensure safe use of electricity, various status signals of a battery are sampled during battery charging or discharging. In this way, whether the battery is operating properly can be determined based on the sampled status signals, thereby ensuring safe charging and/or discharging of the battery.

To achieve high-power and high-capacity discharging, one battery may include a plurality of battery cells. The battery cells may be referred to as a battery pack. These battery cells are connected in series or in parallel.

To ensure safe charging or discharging of the battery, it is required to ensure proper charging and discharging of the battery cells. Therefore, if a battery includes a plurality of battery packs and a battery pack includes a plurality of battery cells, one or more sampling parts may be configured to sample the status signals of the battery packs, so that the battery sampling assembly samples the status signals.

However, it is found through research that sampling parts in the related art are scattered and need to be aligned and welded separately when being connected to a battery pack. This results in low battery assembling efficiency.

In view of this, an embodiment of this disclosure introduces a carrier part. The carrier part is used to fix the first sampling part and the second sampling part used for signal sampling, so as to solve the problem of low battery assembling efficiency caused by scattered first sampling parts and second sampling parts, thereby improving the battery assembling efficiency and reducing the overall production cost of battery assembly.

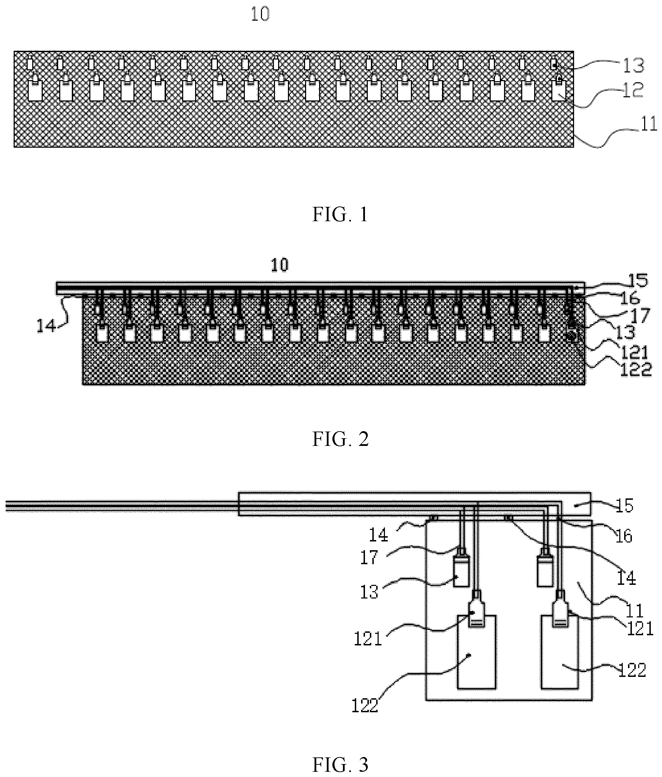

As shown in FIG. 1 to FIG. 4, an embodiment of this disclosure provides a battery sampling assembly 10, including a carrier part 11, a first sampling part 12, and a second sampling part 13;
where the first sampling part 12 and the second sampling part 13 are fixed to the carrier part 11;
the first sampling part 12 is configured to sample a first structure of a battery; and
the second sampling part 13 is configured to sample a second structure of the battery.

The battery sampling assembly 10 may be used as a peripheral circuit for battery cells.

Both the first sampling part 12 and the second sampling part 13 herein may be conductors, and the conductors include, but are not limited to, metal sheets.

The first sampling part 12 and the second sampling part 13 may be electrically connected to a conductive portion of the battery. Through the electrical connections between the first sampling parts 12 and the second sampling parts 13 and the conductive portions of the battery, signals such as a voltage signal, a current signal, and/or a temperature signal can be sampled at corresponding conductive portions.

The electrical connections herein include, but are not limited to, welds and/or contact-type connections between conductors.

For example, the first sampling part 12 may be a metal sheet made of one or more types of metal, and the second sampling part 13 may also be a metal sheet. For example, the second sampling part 13 may be a nickel sheet. The nickel sheet may be a conductor made of nickel metal or a nickel alloy.

The first structure and the second structure may be different portions within the battery.

For example, the first structure may be a high-voltage portion of the battery, and the second structure may be a low-voltage portion of the battery. Electric potential at the high-voltage portion is higher than that at the low-voltage portion. For example, the first structure includes, but is not limited to, a pole, and the second structure may include a housing and the like. The high-voltage portion and the low-voltage portion herein are relative to each other, and the electric potential at the high-voltage portion is higher than that at the low-voltage portion.

In this case, the first sampling part samples an electrical signal at the positive electrode of a battery cell in the battery, and the second sampling part samples an electrical signal at the negative electrode of the battery cell in the battery. The electrical signal includes, but is not limited to, a current signal and/or a voltage signal.

The carrier part 11 includes, but is not limited to, various carriers capable of providing a certain carrying capacity. For example, the carrier part 11 includes, but is not limited to, an insulation film and/or an insulation plate.

The insulation plate herein includes, but is not limited to, various plastic plates or plastic sheets that can be used for fixing the first sampling part 12 and the second sampling part 13.

Due to introduction of the carrier part 11, the first sampling part 12 and the second sampling part 13, which are previously scattered and unfixed, can be fixed relative to each other. In this case, it is unnecessary to align the first sampling parts 12 and the second sampling parts 13 with the battery packs one after another when the battery sampling assembly 10 is being fixed to the battery packs. This simplifies battery manufacturing and improves the battery manufacturing efficiency.

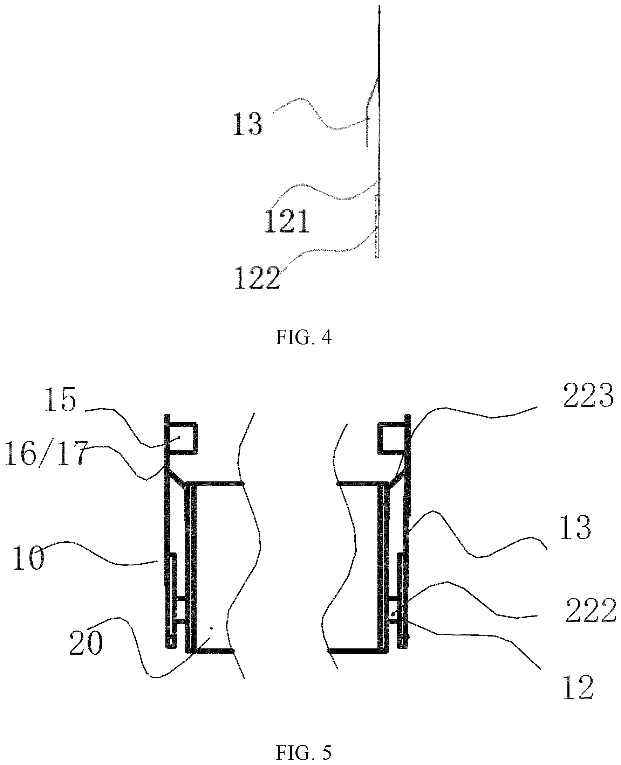

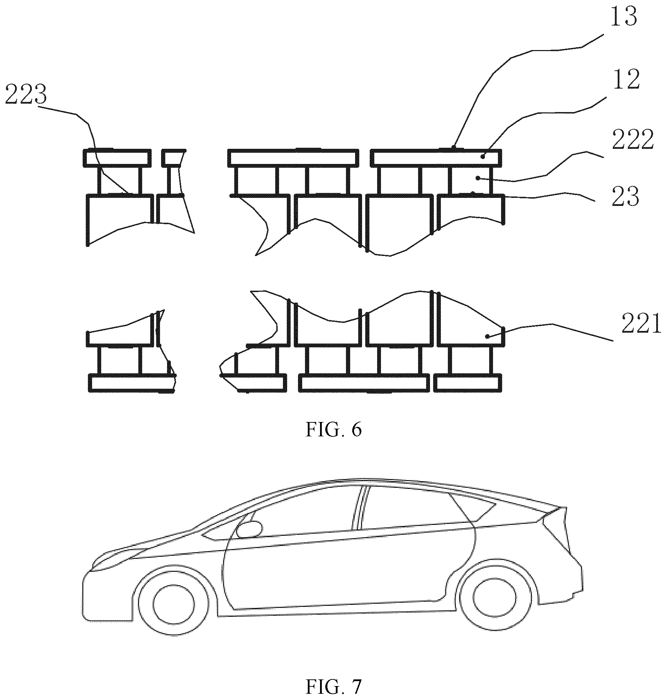

In some embodiments, the battery includes at least a plurality of battery packs, and the first structure includes two poles of opposite polarity of adjacent battery packs. Referring to FIG. 5 and FIG. 6, a battery pack includes poles 222.

Herein, opposite polarity means opposite potential. In the embodiments of this disclosure, the two adjacent poles of opposite polarity refer to a positive electrode pole and a negative electrode pole of two battery packs respectively, for example, a positive electrode pole of a previous battery pack and a negative electrode pole of a current battery pack; or, a negative electrode pole of the previous battery pack and a positive electrode pole of the current battery pack.

One battery pack may include a plurality of battery cells connected in series. For example, one battery pack includes two battery cells connected in series. For the two battery cells connected in series, a positive electrode pole of one battery cell is electrically connected to a negative electrode pole of the other battery cell. The electrical connection herein may be a weld.

The first sampling part 12 is connected to two adjacent poles of opposite polarity. Therefore, the first sampling part 12 also serves as a connector 14 for connecting adjacent battery packs in series.

The first sampling part 12 also samples an electrical signal between the two adjacent battery packs. This is equivalent to sampling a signal at a high-voltage end of a previous battery pack in the series connection.

In an embodiment, a battery may include at least a plurality of battery packs, and the second structure includes a housing of a battery cell in a battery pack.

The housing may include at least a top cover. As shown in FIG. 5 and FIG. 6, the housing may include a top cover 223.

In the embodiments of this disclosure, the battery cell includes a positive electrode pole, a negative electrode pole, and a housing. In a case of continuous connection, electric potential at the positive electrode pole is higher than electric potential at the housing, and the electric potential at the housing is higher than that at the negative electrode pole.

In some cases, the housing and the negative electrode pole can be shortcircuited to reduce signals that need to be sampled. This reduces the quantity of components and complexity of the battery sampling assembly 10, and fewer signal sampling locations need to be arranged on the housing of a battery cell. In this way, if the second sampling part 13 is electrically connected to the housing of a battery cell, when an electrical signal is sampled on the housing, it can be considered that an electrical signal corresponding to the negative electrode pole of the battery cell is sampled.

The electrical signal herein includes, but is not limited to, a current signal and/or a voltage signal.

For example, N first sampling parts 12 are provided and N second sampling parts 13 are provided, where N is a positive integer equal to or greater than 2.

N is a positive integer greater than or equal to 2. This indicates that one battery sampling assembly 10 includes a plurality of separate first sampling parts 12 and second sampling parts 13. If these sampling parts are not fixed to the carrier part 11, the first sampling parts 12 and the second sampling parts 13 may be scattered. In this case, during formation of a battery, these sampling parts need to be aligned with the first structures and the second structures of the battery pack separately. It will be apparent that, this will affect the battery assembling efficiency. In the embodiments of this disclosure, N first sampling parts 12 and N second sampling parts 13 are arranged in a required order and then fixed to the carrier part 11. In this way, the first sampling parts 12 and the second sampling parts 13 in the battery sampling assembly 10 are fixed relative to each other.

In an embodiment, the n-th first sampling part 12 is configured to sample a first pole of the 2n-th battery pack and a second pole of the (2n-1)-th battery pack; and
the n-th second sampling part 13 is configured to sample a housing of the (2n-1)-th battery pack;
where n is a positive integer less than or equal to N.

The 2n-th battery pack and the (2n-1)-th battery pack are two battery packs that are adj acent to each other.

If the first pole is a positive electrode pole, the second pole is a negative electrode pole; or, if the first pole is a negative electrode pole, the second pole is a positive electrode pole.

In this way, the 1st sampling part is connected to two poles of opposite polarity of the 1st battery pack and the 2nd battery pack, and samples electrical signals and the like between the 1st battery pack and the 2nd battery pack.

The second sampling part 13 samples on the housing of the (2n-1)-th battery pack. This indicates that all the second sampling parts 13 of the battery sampling assembly 10 sample signals on the housing of only odd-numbered battery packs in a battery pack array.

In another embodiment, the n-th first sampling part 12 is configured to sample a first pole of the 2n-th battery pack and a second pole of the (2n+1)-th battery pack; where the second pole and the first pole are opposite in polarity; and
the n-th second sampling part 13 is configured to sample a housing of a battery cell in the 2n-th battery pack;
where n is a positive integer less than or equal to N.

In the embodiments of this disclosure, the 1st first sampling part 12 is electrically connected to two poles of opposite polarity of the 2nd battery pack and the 3rd battery pack, and the 1st second sampling part 13 is electrically connected to even-numbered battery packs in the entire battery pack array.

In this way, two battery sampling assemblies 10 can achieve series connection of all battery packs in the battery pack array and signal sampling for the battery packs.

In some embodiments, the battery sampling assembly 10 further includes a circuit board 15.

The circuit board 15 is electrically connected to the first sampling part 12 through a first line 16 and electrically connected to the second sampling part 13 through a second line 17.

The circuit board 15 includes, but is not limited to, various flexible printed circuit boards. The flexible printed circuit board includes, but is not limited to, a flexible flat cable (FFC) board 15 or a flexible printed circuit (FPC) board.

The first line 16 and the second line 17 include, but are not limited to, flexible wires. For example, the first line 16 may include a harness made from one or more flexible wires. The second line 17 may include a harness made from one or more flexible wires.

The circuit board 15 may be a busbar for signals sampled by the first sampling part 12 and the second sampling part 13.

The signals sampled by the first sampling part 12 and the second sampling part 13 on the first structure and the second structure respectively are transmitted through the circuit board 15 to an AMS or controller of the battery or the like.

Thickness of the carrier part 11 is less than thickness of the circuit board 15. Therefore, the overall thickness and volume of the battery is only slightly affected even if the carrier part 11 is provided in the battery sampling assembly 10.

In some embodiments, the battery sampling assembly 10 further includes a connector 14.

The connector 14 connects the circuit board 15 and the carrier part 11.

The connector 14 may be any structure that allows the circuit board 15 and the carrier part 11 to be fixed relative to each other, such as
a connecting plate with specified thickness or strength, a connecting tape, or the like.

The connector 14 may be provided singly or in plurality. When provided in plurality, the connectors 14 are equally spaced to achieve a stress-balanced connection between the carrier part 11 and the circuit board 15.

The carrier part 11 and the circuit board 15 are fixed relative to each other by using the connector 14, improving the integrity of the battery sampling assembly 10.

In some embodiments, the circuit board 15 is a flexible printed circuit board, and the flexible printed circuit board and the carrier part 11 are integrally formed into an integrated structure.

In other words, the integrated structure includes a first region and a second region. A line contained in the circuit board 15 is provided in the first region, and the first sampling part 12 and the second sampling part 13 are provided in the second region.

If the circuit board 15 is an FPC board, because a substrate of the FPC is also a flexible substrate that can provide support to a certain extent, the carrier part 11 and the substrate of the circuit board 15 may be integrated. In this case, the carrier part 11 and the circuit board 15 can be fixed relative to each other without providing additional connector 14 therebetween.

The first sampling part 12 includes:
a first metal sheet 121, electrically connected to a first line 16; and
a second metal sheet 122, laser welded to the first metal sheet 121 and used for electrical connection with two poles of opposite polarity of adjacent battery packs.

The first metal sheet 121 may be made of a metal that can be easily welded to the line. For example, the first metal sheet 121 may be a metal sheet made of nickel metal or a nickel alloy.

The second metal sheet 122 may be made of the same metal as a pole. If the second metal sheet 122 and the pole are made of the same metal, the second metal sheet 122 and the pole can be welded easily. For example, the second metal sheet 122 may be an aluminum metal sheet. The second metal sheet 122 is commonly known as a busbar sheet.

A surface area of the largest surface of the second metal sheet 122 is larger than a surface area of the largest surface of the first metal sheet 121.

The first metal sheet 121 and the second metal sheet 122 may be made of different metal and are laser welded. Through laser welding, which generates a large amount of heat, poor welding between the first metal sheet 121 and the second metal sheet 122 can be reduced, so as to ensure an effective electrical connection between the first metal sheet 121 and the second metal sheet 122.

In some embodiments, the carrier part 11 includes:
a first opening, aligned with a connection region of the first sampling part 12; and
a second opening, aligned with a connection region of the second sampling part 13.

Both the first opening and the second opening may be windows for exposing the first sampling part 12 and the second sampling part 13 that are fixed to the carrier part 11.

The connection region of the first sampling part 12 may be a region for being welded with the first structure.

The connection region of the second sampling part 13 may be a region for being welded with the second structure.

The first opening is aligned with the connection region of the first sampling part 12 so that the connection region can be exposed. This facilitates welding with the first structure when the battery sampling assembly 10 is being mounted in the battery.

If an area of the first sampling part 12 is larger than an area of the second sampling part 13, an area of the first opening is larger than an area of the second opening.

In some embodiments, the carrier part 11 includes a hot-pressing film, and the hot-pressing film is used to fix, by hot pressing, the first sampling part 12 and the second sampling part 13.

The hot-pressing film is a film that can be shaped by means of heating.

The first sampling parts 12 and the second sampling parts 13 are fixed, by means of hot pressing, to the hot-pressing film. The first sampling parts 12 and the second sampling parts 13 are fixed relative to each other by using the hot-pressing film, which reduces the scattering degree of the first sampling parts 12 and the second sampling parts 13.

The hot-pressing film may be of a single layer. In this case, the area of the first opening is smaller than the area of the first sampling part 12, and the area of the second opening is smaller than the area of the second sampling part 13. The hot-pressing film around the first opening adheres to the first sampling part 12 through hot pressing, and the hot-pressing film around the second opening adheres to the second sampling part 13 through hot pressing.

In some embodiments, the hot-pressing film includes:
a first film layer and a second film layer; where the first sampling part 12 and the second sampling part 13 are hot pressed between the first film layer and the second film layer.

The hot-pressing film includes the first film layer and the second film layer, which is equivalent to a two-layer hot-pressing film, and the first sampling part 12 and the second sampling part 13 are provided between the two layers of film. The two-layer hot-pressing film has greater strength and can fix the first sampling part 12 and the second sampling part 13 more reliably at a specific position on the hot-pressing film.

In an embodiment, one surface of the carrier part 11 is provided with an adhesive layer and a protective layer covering a surface of the adhesive layer. The adhesive layer is used to fix the battery sampling assembly 10.

An area of the adhesive layer is smaller than an area of the carrier part 11. The adhesive layer may be provided singly or in plurality, and provided on one surface of the carrier part 11.

The adhesive layer may be dotted adhesive layers in the shape of a circle, a rectangle, or the like, and multiple dotted adhesive layers are provided at different locations of the carrier part 11, for example, at one end of the carrier part 11 close to the circuit board 15 and/or away from the circuit board 15.

The adhesive layer may be a strip adhesive layer, and the strip adhesive layer may be provided at one end of the carrier part 11 close to the circuit board 15 and/or away from the circuit board 15. When the battery sampling assembly 10 is being assembled in the battery, the adhesive layer may be used to fix in advance the battery sampling assembly 10 to a battery array formed by battery packs. Then, the first sampling part 12 and the second sampling part 13 in the battery sampling assembly 10 are fixedly connected to the first structure and the second structure of the battery packs, further improving the battery assembling efficiency.

As shown in FIG. 5 and FIG. 6, an embodiment of this disclosure provides a battery, including:
any one of the foregoing battery sampling assemblies 10.

The battery uses any one of the foregoing battery sampling assemblies 10, and in the battery sampling assembly 10, a carrier part is used to fix the first sampling part and the second sampling part. Therefore, the battery is characterized by a high battery assembling efficiency.

The battery is a traction battery. The power battery is also known as a secondary battery. The battery may be a lithium battery, a sodium battery, or a magnesium battery.

In some embodiments, the battery includes:
a battery pack 20, with one battery pack including two battery cells 221 connected in series;
where the battery pack 20 is electrically connected to the battery sampling assembly 10.

The battery pack 20 includes two battery cells connected in series. In this way, the battery capacity of a battery pack is increased and the technical difficulty is reduced compared with the manufacturing of a single battery cell with a high capacity.

The battery cell 221 includes a pole 222 and a top cover 223. For example, the top cover 233 has a nickel sheet, and the nickel sheet may be connected to the second sampling assembly 13.

In the embodiments of this disclosure, the battery sampling assembly 10 is connected to the battery pack 20.

For example, 2S battery packs 20 are provided, where S is a positive integer greater than or equal to 2.

The battery sampling assembly 10 includes a first battery sampling assembly 10 and a second battery sampling assembly 10.

The first battery sampling assembly includes S first sampling parts and S second sampling parts.

The second battery sampling assembly includes S-1 first sampling parts and S-1 second sampling parts.

The second sampling parts of the first battery sampling assembly each are electrically connected to a housing of an odd-numbered battery pack; and the second sampling parts of the second battery sampling assembly each are electrically connected to a housing of an even-numbered battery pack.

That is, one battery includes two battery sampling assemblies 10. The 2S battery packs are arranged to form a battery pack array.

The first battery sampling assembly and the second battery sampling assembly may be distributed on two sides of the battery pack array.

For the battery sampling assembly 10 provided in the embodiments of this disclosure, the first sampling part and the second sampling part are fixed by the carrier part, and therefore the battery assembling efficiency is improved.

An embodiment of this disclosure further provides an electric device, and the electric device includes the battery provided in any one of the foregoing technical solutions.

The electric device includes, but is not limited to, various devices using a battery. For example, the electric device includes, but is not limited to, a mobile phone, a tablet computer, a laptop computer, an electric toy, an electric bicycle, an electric vehicle, a ship, or a spacecraft. The electric toy may be a fixed or mobile electric toy, for example, a game console, an electric toy car, an electric toy ship, and an electric toy airplane. The spacecraft may include an airplane, a rocket, a space shuttle, a spaceship, and the like.

FIG. 7 shows an electric vehicle.

Referring to FIG. 1 to FIG. 4, this embodiment proposes a structure where high-voltage and low-voltage connections are integrated. In this structure, low-voltage electrical signals can be sampled at the busbar sheet and the top cover of a battery cell for a battery pack (Pack) with poles provided on two ends.

Harnesses are arranged in an orderly manner on an FFC board, and a nickel sheet is connected to an end of each harness for welding and sampling. The FFC herein is one of the foregoing circuit boards 15. The harness herein may be the foregoing second line 17.

The nickel sheets to be connected to the ends of half of harnesses may be connected to a busbar sheet in advance by means of laser penetration welding, so that a voltage at the pole of each cell can be sampled. The combination of the nickel sheet and the busbar sheet herein constitutes one type of the foregoing first sampling parts.

The nickel sheets to be connected to the ends of the other half of harnesses are used for sampling a voltage signal at the top cover of a cell, and are not welded in advance but compressed and welded after being assembled to the cell in a battery pack production process. The sheet is one type of the foregoing second sampling parts.

The second sampling part is fixed only by connecting to a harness, and the harness is flexible. Therefore, the position of the nickel sheet is not fixed when received and needs to be fixed manually before assembling and welding. For this reason, automated welding cannot be implemented, which is the root cause of failure to achieve automated mass production of FFCs.

This embodiment proposes the use of hot pressing. That is, two pieces of hot-pressing film are compressed to hold all busbar sheets and nickel sheets (second sampling parts) therebetween through heating and pressing techniques. In this way, each nickel sheet and the busbar sheet are fixed relative to each other, solving the problem that the FFC flexible harnesses cannot be industrialized. Openings need to be reserved before the two pieces of hot-pressing film are hot pressed, so that to-be-welded positions of the busbar sheet and the nickel sheet can be exposed after the hot pressing.

Hot pressing is performed to fix the ends of only part of harnesses and part of nickel sheets connected to the ends, so as to prevent poor welding due to assembly gaps caused by an excessively large area of hot-pressing film.

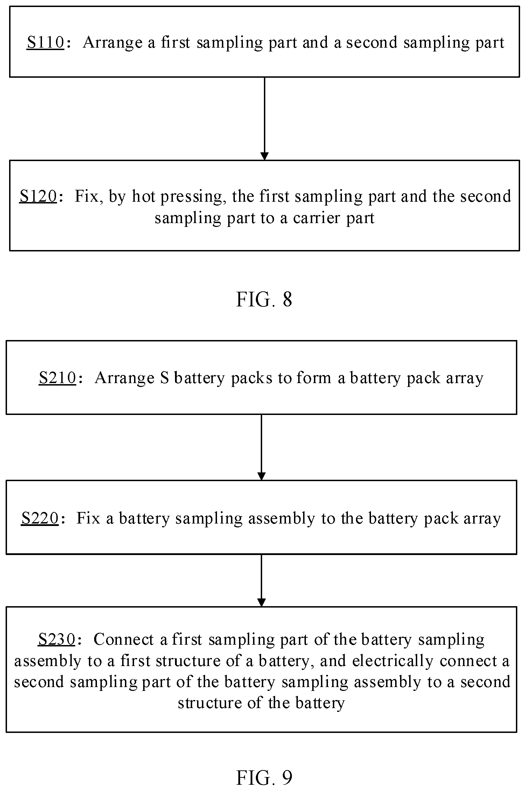

As shown in FIG. 8, an embodiment of this disclosure provides a method for manufacturing a battery sampling assembly. The method includes the following steps.

S 110. Arrange a first sampling part and a second sampling part.

S 120. Fix, by hot pressing, the first sampling part and the second sampling part to a carrier part.

The first sampling part and the second sampling part are arranged according to their connection with a first structure and a second structure of the battery.

After being arranged, the first sampling part and the second sampling part are fixed to the carrier part by means of hot pressing or bonding.

For example, the first sampling part and the second sampling part are arranged on the carrier part and then fixed, for example, by means of hot pressing, to the carrier part.

For another example, the first sampling part and the second sampling part are arranged, the carrier part is laid on the arranged first sampling part and second sampling part, and then the first sampling part and the second sampling part are fixed to the carrier part.

The first sampling part and the second sampling part manufactured using this method are connected through the carrier part. In this way, the battery sampling assembly is assembled in the battery without additional fixing of each of the first sampling parts and the second sampling parts separately, and the battery assembling efficiency is improved.

In some embodiments, before fixing the first sampling part and the second sampling part to a carrier part, the method further includes:
electrically connecting a first line of a circuit board and the first sampling part; and
electrically connecting a second line of the circuit board and the second sampling part.

Both the first line and the second line may be flexible wires or small circuit boards. For example, a connecting terminal is provided on two ends of both the first line and the second line board, and the connecting terminal at one end may be inserted into an outlet of the circuit board. The connecting terminal at the other end is welded to the first sampling part or the second sampling part.

For example, the first line and the second line may form a harness. The harness may also be fixed to the carrier part.

The first sampling part and the second sampling part are fixed to the carrier part after being electrically connected to the circuit board. This can reduce problems arising from electrically connecting the circuit board to the first sampling part and the second sampling part after the first sampling part and the second sampling part are fixed, as opposed to electrically connecting the first sampling part and the second sampling part the circuit board after fixing the first sampling part and the second sampling part to the carrier part.

In some embodiments, the method further includes fixing the carrier part and the circuit board by using a connector.

Fixing the carrier part and the circuit board by using a connector can improve integrity of the circuit board and the carrier part.

In some embodiments, the first sampling part and the second sampling part may be fixed to the carrier part before the carrier part and the circuit board are fixed by using a connector.

In some other embodiments, the carrier part and the circuit board may be fixed before the first sampling part and the second sampling part are fixed to the carrier part.

As shown in FIG. 9, an embodiment of this disclosure provides a battery manufacturing method. The method includes the following steps.

S210. Arrange S battery packs to form a battery pack array.

S220. Fix a battery sampling assembly to the battery pack array.

S230. Connect a first sampling part of the battery sampling assembly to a first structure of a battery, and electrically connect a second sampling part of the battery sampling assembly to a second structure of the battery.

The battery manufacturing method may at least include fixing the battery sampling assembly to the battery pack array.

The battery sampling assembly includes a carrier part. In this case, the plurality of first sampling parts and second sampling parts of the battery sampling assembly can be conveniently aligned with the first structures and the second structures of the battery pack array. This shortens the time for aligning the sampling parts with corresponding structures on the battery during battery manufacturing, thereby improving the manufacturing efficiency.

In some embodiments, the first structure includes two poles of opposite polarity of adjacent battery packs.

The two poles of opposite polarity herein are a positive electrode pole and a negative electrode pole. The positive electrode pole is connected to a positive electrode tab of a positive electrode plate within the battery cell. The negative electrode pole is connected to a negative electrode tab of a negative electrode plate within the battery cell.

A first sampling part may be welded to a first structure to implement an electrical connection between the first sampling part and the first structure.

In some embodiments, the second structure includes a housing of a battery cell in a battery pack.

The housing herein may be an aluminum shell.

A second sampling part may be welded to a second structure to implement an electrical connection between the second sampling part and the second structure.

In some embodiments, connecting a first sampling part of the battery sampling assembly to a first structure of a battery, and electrically connecting a second sampling part of the battery sampling assembly to a second structure of the battery includes:
electrically connecting the n-th first sampling part of the first battery sampling assembly to a first pole of the 2n-th battery pack and a second pole of the (2n-1)-th battery pack; and
electrically connecting the n-th first sampling part of the second battery sampling assembly to the first pole of the 2n-th battery pack and a second pole of the (2n+1)-th battery pack;
   or,
electrically connecting the n-th second sampling part of the first battery sampling assembly to a housing of the (2n-1)-th battery pack; and
electrically connecting the n-th second sampling part of the second battery sampling assembly to a housing of a battery cell in the 2n-th battery pack.

In some embodiments, fixing a battery sampling assembly to the battery pack array includes:
removing a protective layer on the back of a carrier part of the battery sampling assembly to expose an adhesive layer covered by the protective layer; and
bonding the battery sampling assembly to the battery pack array by using the adhesive layer.

When the protective layer on the back of the carrier part is removed, the adhesive layer is exposed.

The adhesive layer may be used to fix the battery sampling assembly to the battery pack array in advance. After the battery sampling assembly is fixed to the battery pack array in advance, the first sampling parts are welded to the first structures, and the second sampling parts are welded to the second structures.

In conclusion, it should be noted that the above embodiments are merely intended for describing the technical solutions of this disclosure but not for limiting this disclosure. Although this disclosure is described in detail with reference to the foregoing embodiments, persons of ordinary skill in the art should understand that they may still make modifications to the technical solutions described in the foregoing embodiments or make equivalent replacements to some or all technical features thereof without departing from the scope of the technical solutions of the embodiments of this disclosure. They should all be covered in the scope of the claims and specification of this disclosure. In particular, as long as there is no structural conflict, the various technical features mentioned in the embodiments can be combined in any manner. This disclosure is not limited to the specific embodiments disclosed in this specification but includes all technical solutions falling within the scope of the claims.

## Claims

1. A battery sampling assembly, **characterized by** comprising a carrier part, a first sampling part, and a second sampling part;
wherein the first sampling part and the second sampling part are fixed to the carrier part;
the first sampling part is configured to sample a first structure of a battery; and
the second sampling part is configured to sample a second structure of the battery.

2. The battery sampling assembly according to claim 1, **characterized in that** the battery comprises a plurality of battery packs, and the first structure comprises two poles of opposite polarity of adjacent battery packs.

3. The battery sampling assembly according to claim 1 or 2, **characterized in that** the battery comprises a plurality of battery packs, and the second structure comprises a housing of a battery cell in a battery pack.

4. The battery sampling assembly according to any one of claims 1 to 3, **characterized in that** the first sampling part is provided in a quantity of N and the second sampling part is provided in a quantity of N, wherein N is a positive integer equal to or greater than 2.

5. The battery sampling assembly according to claim 4, **characterized in that**
the n-th first sampling part is configured to sample a first pole of the 2n-th battery pack and a second pole of the (2n-1)-th battery pack; and
the n-th second sampling part is configured to sample a housing of the (2n-1)-th battery pack;
wherein n is a positive integer less than or equal to N.

6. The battery sampling assembly according to claim 4, **characterized in that**
the n-th first sampling part is configured to sample a first pole of the 2n-th battery pack and a second pole of the (2n+1)-th battery pack; wherein the second pole and the first pole are opposite in polarity; and
the n-th second sampling part is configured to sample a housing of a battery cell in the 2n-th battery pack;
wherein n is a positive integer less than or equal to N.

7. The battery sampling assembly according to any one of claims 1 to 6, **characterized in that** the battery sampling assembly further comprises a circuit board; wherein
the circuit board is electrically connected to the first sampling part through a first line and electrically connected to the second sampling part through a second line.

8. The battery sampling assembly according to any one of claims 1 to 7, **characterized in that** the battery sampling assembly further comprises a connector; wherein
the connector connects the circuit board and the carrier part.

9. The battery sampling assembly according to claim 7, **characterized in that** the circuit board is a flexible printed circuit board, and the flexible printed circuit board and the carrier part are integrally formed into an integrated structure.

10. The battery sampling assembly according to claim 8 or 9, **characterized in that** the first sampling part comprises:
a first metal sheet, electrically connected to the first line; and
a second metal sheet, laser welded to the first metal sheet and used for electrical connection with two poles of opposite polarity of adjacent battery packs.

11. The battery sampling assembly according to any one of claims 1 to 10, **characterized in that** the carrier part comprises:
a first opening, aligned with a connection region of the first sampling part; and
a second opening, aligned with a connection region of the second sampling part.

12. The battery sampling assembly according to any one of claims 1 to 11, **characterized in that** the carrier part comprises a hot-pressing film, and the hot-pressing film is used to fix, by hot pressing, the first sampling part and the second sampling part.

13. The battery sampling assembly according to claim 12, **characterized in that** the hot-pressing film comprises:
a first film layer and a second film layer; wherein the first sampling part and the second sampling part are hot pressed between the first film layer and the second film layer.

14. The battery sampling assembly according to any one of claims 1 to 13, **characterized in that**
one surface of the carrier part is provided with an adhesive layer and a protective layer covering a surface of the adhesive layer; wherein
the adhesive layer is used to fix the battery sampling assembly.

15. A battery, **characterized by** comprising:
the battery sampling assembly according to any one of claims 1 to 14.

16. The battery according to claim 15, **characterized in that** the battery comprises:
a battery pack, with one battery pack comprising two battery cells connected in series;
wherein the battery pack is electrically connected to the battery sampling assembly.

17. The connecting apparatus according to claim 16, **characterized in that** the battery pack is provided in a quantity of 2S; wherein S is a positive integer greater than or equal to 2;
the battery sampling assembly comprises a first battery sampling assembly and a second battery sampling assembly;
the first battery sampling assembly comprises S first sampling parts and S second sampling parts; and
the second battery sampling assembly comprises S-1 first sampling parts and S-1 second sampling parts;
wherein the second sampling parts of the first battery sampling assembly each are electrically connected to a housing of an odd-numbered battery pack; and the second sampling parts of the second battery sampling assembly each are electrically connected to a housing of an even-numbered battery pack.

18. An electric device, **characterized in that** the electric device comprises:
the battery according to any one of claims 15 to 17.

19. A method for manufacturing a battery sampling assembly, **characterized by** comprising:
arranging a first sampling part and a second sampling part; and
fixing, by hot pressing, the first sampling part and the second sampling part to a carrier part.

20. The method according to claim 19, **characterized in that**: before fixing the first sampling part and the second sampling part to the carrier part, the method further comprises:
electrically connecting a first line of a circuit board and the first sampling part; and
electrically connecting a second line of the circuit board and the second sampling part.

21. The method according to claim 20, **characterized in that** the method further comprises:
fixing the carrier part and the circuit board by using a connector.

22. A battery manufacturing method, **characterized by** comprising:
arranging S battery packs to form a battery pack array;
fixing a battery sampling assembly to the battery pack array; and
connecting a first sampling part of the battery sampling assembly to a first structure of a battery, and electrically connecting a second sampling part of the battery sampling assembly to a second structure of the battery.

23. The manufacturing method according to claim 22, **characterized in that** the first structure comprises two poles of opposite polarity of adjacent battery packs.

24. The manufacturing method according to claim 22 or 23, **characterized in that** the second structure comprises a housing of a battery cell in a battery pack.

25. The method according to claim 22, **characterized in that** connecting a first sampling part of the battery sampling assembly to a first structure of a battery, and electrically connecting a second sampling part of the battery sampling assembly to a second structure of the battery comprises:
electrically connecting the n-th first sampling part of the first battery sampling assembly to a first pole of the 2n-th battery pack and a second pole of the (2n-1)-th battery pack; and
electrically connecting the n-th first sampling part of the second battery sampling assembly to a first pole of the 2n-th battery pack and a second pole of the (2n+1)-th battery pack;
or,
electrically connecting the n-th second sampling part of the first battery sampling assembly to a housing of the (2n-1)-th battery pack; and
electrically connecting the n-th second sampling part of the second battery sampling assembly to a housing of a battery cell in the 2n-th battery pack.

26. The method according to claim 25, **characterized in that** fixing a battery sampling assembly to the battery pack array comprises:
removing a protective layer on the back of a carrier part of the battery sampling assembly to expose an adhesive layer covered by the protective layer; and
bonding the battery sampling assembly to the battery pack array by using the adhesive layer.
